(19) Europäisches Patentamt
European Patent Office
Office européen des brevets

(11) **EP 4 195 281 A1**

(12) **EUROPEAN PATENT APPLICATION**
published in accordance with Art. 153(4) EPC

(43) Date of publication:
**14.06.2023 Bulletin 2023/24**

(21) Application number: **21854518.4**

(22) Date of filing: **05.07.2021**

(51) International Patent Classification (IPC):
*H01L 27/146* (2006.01)        *H01L 27/144* (2006.01)
*H04N 5/369* (2011.01)

(52) Cooperative Patent Classification (CPC):
**H01L 27/144; H01L 27/146; H04N 25/70;**
Y02E 10/549

(86) International application number:
**PCT/JP2021/025294**

(87) International publication number:
**WO 2022/030155 (10.02.2022 Gazette 2022/06)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **04.08.2020   JP 2020132669**

(71) Applicant: **Panasonic Intellectual Property
Management Co., Ltd.
Osaka-shi, Osaka 540-6207 (JP)**

(72) Inventors:
• **TOMEKAWA ,Yuuko
Osaka-shi, Osaka 540-6207 (JP)**
• **YAMADA, Shota
Osaka-shi, Osaka 540-6207 (JP)**

(74) Representative: **Grünecker Patent- und
Rechtsanwälte
PartG mbB
Leopoldstraße 4
80802 München (DE)**

(54)   **IMAGING DEVICE**

(57)   An imaging device includes a first electrode, a second electrode, a photoelectric conversion layer, and a charge storage region. The photoelectric conversion layer is located between the first electrode and the second electrode. The charge storage region is electrically connected to the first electrode. An area of the charge storage region in plan view is smaller than or equal to $0.04\ \mu m^2$.

FIG. 4

**Description**

Technical Field

The present disclosure relates to an imaging device.

Background Art

An imaging device includes a photoelectric converter. The photoelectric converter converts light into electric charge. The imaging device reads out a signal corresponding to the electric charge. Imaging devices of PTLs 1 and 2 each include a photodiode used as a photoelectric converter.
An imaging device may be used under a radiation environment. PTLs 1 and 2 each propose an imaging device in consideration for use under a radiation environment.

Citation List

Patent Literature

PTL 1: International Publication No. 2016/013227
PTL 2: International Publication No. 2019/221095

Summary of Invention

Technical Problem

When an imaging device is placed under a radiation environment, the quality of an image that is obtained by an imaging device may deteriorate. The technologies of PTLs 1 and 2 have room for improvement from this point of view.

Solution to Problem

An aspect of the present disclosure provides an imaging device including:

a first electrode;
a second electrode;
a photoelectric conversion layer located between the first electrode and the second electrode; and
a charge storage region electrically connected to the first electrode,
wherein an area of the charge storage region in plan view is smaller than or equal to 0.04 $\mu m^2$.

Advantageous Effects of Invention

Reducing the area of the charge storage region as noted above makes it hard for the quality of an image that is obtained by the imaging device to deteriorate even when the imaging device is exposed to radiation.

Brief Description of Drawings

[Fig. 1] Fig. 1 is a configuration diagram of an imaging device.
[Fig. 2] Fig. 2 is a circuit diagram of the imaging device.
[Fig. 3] Fig. 3 is a plan view showing an internal layout of a pixel.
[Fig. 4] Fig. 4 is a schematic cross-sectional view of a device structure of the pixel.
[Fig. 5] Fig. 5 is a graph showing a relationship between the area of a charge storage region in plan view and a pixel failure probability.
[Fig. 6] Fig. 6 is an explanatory diagram showing a spacing between a first contact hole and a first gate electrode in plan view.

Description of Embodiments

(Underlying Knowledge Forming Basis of the Present Disclosure)

There is an ongoing shift in space industry from state undertaking to private undertaking. This shift brings about the development of innovations and the rise of a large number of new businesses. The space industry is ranked as a growth industry.

In the space industry, imaging from the space may play an important role. It is desirable that imagine from the space be executed with high accuracy and high reliability. This makes high-accuracy positioning services and high-resolution image capture possible. This also makes it possible to improve the quality of data and increase the amount of data in obtaining data through earth observations based on a nanosatellite constellation.

In a space environment, the density of radiation such as proton beams, neutron beams, $\gamma$-rays, and $\alpha$-rays is high. For this reason, even equipment that delivers outstanding performance on earth may not deliver outstanding performance in a space environment. Specifically, when an imaging device is placed under a radiation environment, the quality of an image that is obtained by the imaging device may deteriorate.

The imaging device may be exposed to radiation in an environment other than a space environment. Examples of such environments include an aeronautical environment, an environment exposed to reactor-derived radiation, and an environment exposed to medical radiation.

(Brief Overview of Aspect according to the Present Disclosure)

An imaging device according to a first aspect of the present disclosure includes:

a first electrode;
a second electrode;
a photoelectric conversion layer located between the first electrode and the second electrode; and
a charge storage region electrically connected to the first electrode. An area of the charge storage region in plan view is smaller than or equal to 0.04 $\mu m^2$.

Reducing the area of the charge storage region as in the case of the first aspect makes it hard for the quality of an image that is obtained by the imaging device to deteriorate even when the imaging device is exposed to radiation. The quality of an image that is obtained by the imaging device may be hereinafter referred to simply as "image quality".

In a second aspect of the present disclosure, for example, in the imaging device according to the first aspect, the area of the charge storage region in plan view may be smaller than or equal to 0.034 $\mu m^2$.

Reducing the area of the charge storage region as in the case of the second aspect makes it hard for image quality to deteriorate eve when the imaging device is exposed to radiation.

In a third aspect of the present disclosure, for example, in the imaging device according to the second aspect, the area of the charge storage region in plan view may be smaller than or equal to 0.01 $\mu m^2$.

Reducing the area of the charge storage region as in the case of the third aspect makes it hard for image quality to deteriorate eve when the imaging device is exposed to radiation.

In a fourth aspect of the present disclosure, for example, the imaging device according to any one of the first to third aspects may further include a pixel including:

the first electrode;
the second electrode;
the photoelectric conversion layer; and
the charge storage region,
wherein a ratio of the area of the charge storage region in plan view to an area of the pixel in plan view may be lower than or equal to 0.44%.

Reducing the ratio of the area of the charge storage region as in the case of the fourth aspect makes it hard for image quality to deteriorate eve when the imaging device is exposed to radiation.

In a fifth aspect of the present disclosure, for example, in the imaging device according to any one of the first to fourth aspects, the photoelectric conversion layer may contain an organic material as a major ingredient.

Selecting the major ingredient of the photoelectric conversion layer as in the case of the fifth aspect makes it hard for image quality to deteriorate eve when the imaging device is exposed to radiation.

In a sixth aspect of the present disclosure, for example, in the imaging device according to any one of the first to fifth aspects, a thickness of the photoelectric conversion layer may be less than or equal to 1 $\mu m$.

Reducing the thickness of the photoelectric conversion layer as in the case of the sixth aspect makes it hard for image quality to deteriorate eve when the imaging device is exposed to radiation.

In a seventh aspect of the present disclosure, for example, in the imaging device according to any one of the first to sixth aspects, the charge storage region may contain an n-type impurity.

The n type employed in the seventh aspect is an example of a conductivity type of an impurity contained in the charge storage region.

In an eighth aspect of the present disclosure, for example, in the imaging device according to any one of the first to seventh aspects, the charge storage region may contain a substance other than boron as a major impurity.

Selecting the major impurity as in the case of the eighth aspect makes it hard for image quality to deteriorate eve when the imaging device is exposed to radiation.

In a ninth aspect of the present disclosure, for example, in the imaging device according to any one of the first to eighth aspects, the charge storage region may contain, as a major impurity, a substance whose atomic number is larger than that of boron.

Selecting the major impurity as in the case of the ninth aspect makes it hard for image quality to deteriorate eve when the imaging device is exposed to radiation.

In a tenth aspect of the present disclosure, for example, the imaging device according to any one of the first to ninth aspects may further include:

    a first transistor; and
    a second transistor, wherein
    the first transistor may include a first source, a first drain, and a first gate electrode,
    the second transistor may include a second gate electrode,
    the first source or the first drain may be the charge storage region,
    the second gate electrode may be electrically connected to the charge storage region, and
    an area of the second gate electrode in plan view may be smaller than an area of the first gate electrode in plan view.

The tenth aspect makes it easy to reduce a dark current.

In an eleventh aspect of the present disclosure, for example, the imaging device according to any one of the first to tenth aspects may further include:

    a first transistor;
    a first contact plug; and
    a first contact hole, wherein
    the first transistor may include a first source, a first drain, and a first gate electrode,
    the first source or the first drain may be the charge storage region,
    the first contact plug may electrically connect the first electrode to the charge storage region by being connected to the charge storage region via the first contact hole, and
    a spacing between the first contact hole and the first gate electrode in plan view may be smaller than or equal to 0.2 $\mu$m.

The eleventh aspect makes it easy to reduce the area of the charge storage region in plan view.

In a twelfth aspect of the present disclosure, for example, the imaging device according to any one of the first to eleventh aspects may further include a pixel including:

    the first electrode;
    the second electrode;
    the photoelectric conversion layer; and
    the charge storage region,
    wherein the pixel need not include a photodiode.

The pixel of the twelfth aspect does not include a photodiode. Therefore, even when the imaging device is exposed to radiation, a signal that the pixel outputs hardly deteriorates.

In a thirteenth aspect of the present disclosure, for example, the imaging device according to any one of the first to twelfth aspects may be used under an environment exposed to radiation. In other words, the imaging device may be an imaging device for taking an image in an environment exposed to radiation.

The radiation environment of the thirteenth aspect is an environment in which the imaging device may be used.

An imaging device according to a fourteenth aspect of the present disclosure includes:

    a first electrode;

a second electrode;
a photoelectric conversion layer located between the first electrode and the second electrode;
a first transistor;
a first contact plug; and
a first contact hole. The first transistor includes a first source, a first drain, and a first gate electrode. The first source or the first drain is the charge storage region. The first contact plug electrically connects the first electrode to the charge storage region by being connected to the charge storage region via the first contact hole. A spacing between the first contact hole and the first gate electrode in plan view is smaller than or equal to 0.2 $\mu$m.

The fourteenth aspect makes it easy to reduce the area of the charge storage region in plan view. Reducing the area of the charge storage region in plan view makes it hard for image quality to deteriorate even when the imaging device is exposed to radiation.

An imaging device according to a fifteenth aspect of the present disclosure includes a pixel including:

a first electrode;
a second electrode;
a photoelectric conversion layer located between the first electrode and the second electrode; and
a charge storage region electrically connected to the first electrode,
wherein a ratio of the area of the charge storage region in plan view to an area of the pixel in plan view is lower than or equal to 0.44%.

Setting an upper limit on the ratio of the area of the charge storage region as in the case of the fifteenth aspect makes it hard for image quality to deteriorate even when the imaging device is exposed to radiation.

The technologies of the first to fifteenth aspects may be arbitrarily combined unless a contradiction arises.

The following describes an embodiment of the present disclosure with reference to the drawings. It should be noted that the present disclosure is not limited by the embodiment.

In the embodiment, terms such as "upper" and "lower" are used solely for designating the mutual arrangement of members, and are not intended to limit the attitude of an imaging device during use.

In the embodiment, under a first definition, the term "plan view" refers to a view as seen from a direction parallel with the thickness of a first electrode. Under a second definition, the term "plan view" refers to a view as seen from a direction parallel with the thickness of a semiconductor substrate. In the embodiment, a view that can be said on the basis of at least either of the first and second definitions to be a "plan view" is treated as a "plan view".

In the following embodiment, adjustments of elements entailed by a changing of signal charge between positive and negative, such as changes in conductivity type of impurity regions, may be made as appropriate. Further, the rewording of terms entailed by a changing of signal charge between positive and negative may be done as appropriate.

(Embodiment)

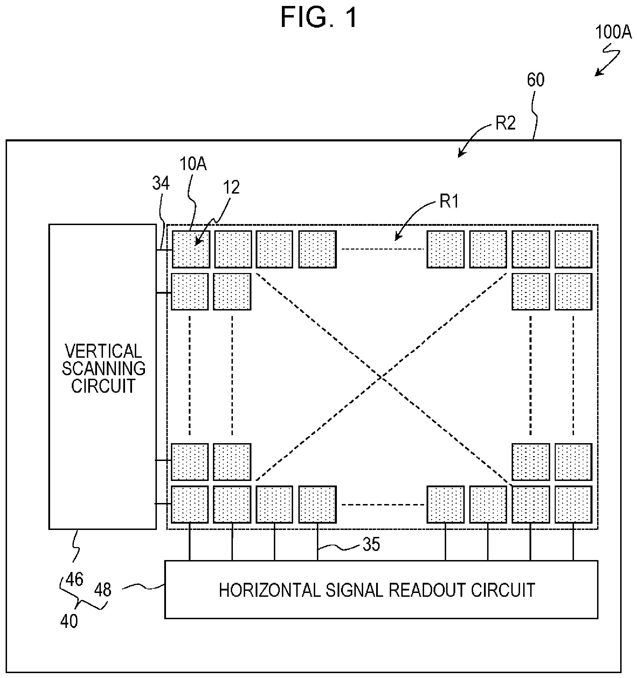

Fig. 1 is a configuration diagram of an imaging device according to the present embodiment. An imaging device 100A according to the present embodiment is a stacked imaging device.

As shown in Fig. 1, the imaging device 100A includes a plurality of pixels 10A and a peripheral circuit 40. The plurality of pixels 10A and the peripheral circuit 40 are provided on a semiconductor substrate 60. Each of the pixels 10A includes a photoelectric converter 12. The photoelectric converter 12 is disposed above the semiconductor substrate 60.

In the example shown in Fig. 1, the pixels 10A are arranged in a matrix with m rows and n columns. Note here that m and n are each an integer greater than or equal to 2. The pixels 10A constitute an imaging region R1 by being two-dimensionally arrayed on the semiconductor substrate 60. The imaging region R1 is defined as a region of the semiconductor substrate 60 covered by the photoelectric converters 12.

For ease of explanation, Fig. 1 shows the photoelectric converter 12 of each of the pixels 10A as being spatially isolated from that of the other of the pixels 10A. Note, however, that the photoelectric converters 12 of the plurality of pixels 10A may be disposed on top of the semiconductor substrate 60 without spacings therebetween.

The number of pixels 10A that are included in the imaging device 100A may be 1. The pixels 10A may be one-dimensionally arrayed. In this case, the imaging device 100A may be used as a line sensor.

In the illustrate example, the center of each of the pixels 10A is located at a lattice point of a tetragonal lattice. Note, however, the pixels 10A may not be arranged in such a manner. For example, the plurality of pixels 10A may be arranged such that the center of each of the pixels 10A is located at a lattice point of a triangular lattice, a hexagonal lattice, or other lattices.

In the configuration illustrated in Fig. 1, a peripheral region R2 is provided outside the imaging region R1. The peripheral region R2 includes the peripheral circuit 40 The peripheral circuit 40 includes a vertical scanning circuit 46 and a horizontal signal readout circuit 48.

The vertical scanning circuit 46 is connected to a plurality of address signal lines 34. The plurality of address signal lines 34 and a plurality of rows constituted by the plurality of pixels 10A are associated in one-to-one correspondence with each other. The vertical scanning circuit 46 is also called "row scanning circuit".

The horizontal signal readout circuit 48 is connected to a plurality of vertical signal lines 35. The plurality of vertical signal lines 35 and a plurality of columns constituted by the plurality of pixels 10A are associated in one-to-one correspondence with each other. The horizontal signal readout circuit 48 is also called "column scanning circuit".

The peripheral circuit 40 may further include a signal processing circuit, an output circuit, a control circuit, a power source that supplies a predetermined voltage to each of the pixels 10A, or other components. Part of the peripheral circuit 40 may be disposed on top of another substrate that is different from the semiconductor substrate 60, on which the pixels 10A are provided.

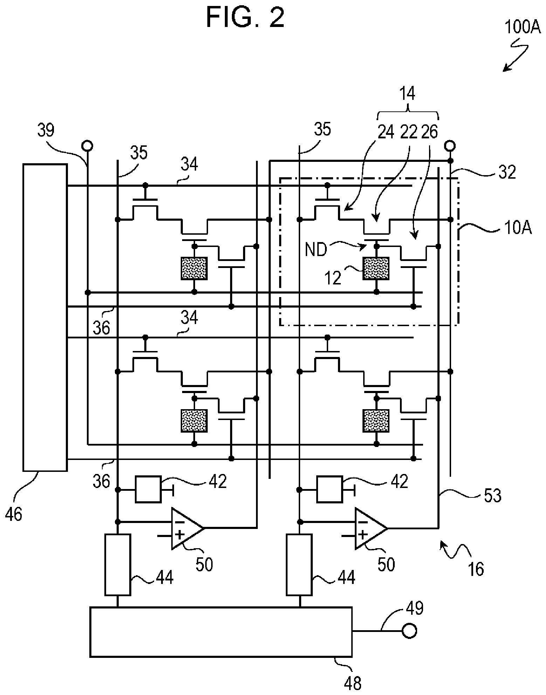

Fig. 2 is a diagram showing a circuit configuration of the imaging device 100A according to the embodiment. To avoid a complex drawing, Fig. 2 shows four of the plurality of pixels 10A shown in Fig. 1 that are arrayed in two rows and two columns.

Light is incident on the photoelectric converter 12 of each of the pixels 10A. This causes positive and negative charges to be generated in the photoelectric converter 12. The positive and negative charges are typically a hole-electron pair.

The photoelectric converter 12 of each of the pixels 10A is connected to a storage control line 39. While the imaging device 100A is operating, a predetermined voltage is applied to the storage control line 39. As a result of this, either of the positive and negative charges generated by the photoelectric conversion can be selectively stored in the charge storage region.

The following illustrates a case where the positive one of the positive and negative charges generated by the photoelectric conversion is used as signal charge. Note, however, that the negative charge too may be used as signal charge.

Each of the pixels 10A includes a signal detection circuit 14. The signal detection circuit 14 is electrically connected to the photoelectric converter 12. In the configuration illustrated in Fig. 2, the signal detection circuit 14 includes an amplifying transistor 22 and a reset transistor 26. In this example, the signal detection circuit 14 further includes an address transistor 24.

The amplifying transistor 22 is also called "readout transistor". The address transistor 24 is also called "row selection transistor".

The amplifying transistor 22, the reset transistor 26, and the address transistor 24 are typically field-effect transistors (FETs) provided on the semiconductor substrate 60, which supports the photoelectric converter 12. Unless otherwise noted, the following describes an example in which N-channel MOS (metal-oxide semiconductor) FETs are used as the amplifying transistor 22, the reset transistor 26, and the address transistor 24. It should be noted that whether which of the two diffusion layers of an FET corresponds to a source or a drain is determined by the polarity of the FET and how high or low a potential is at that point in time. Therefore, whether which is a source or a drain may vary depending on the operating condition of the FET.

As schematically shown in Fig. 2, the amplifying transistor 22 has its gate electrode electrically connected to the photoelectric converter 12. A charge storage node ND is provided between the photoelectric converter 12 and the amplifying transistor 22. The charge storage node ND is also called "floating diffusion node".

The charge storage node ND includes a charge storage region FD and a wire. The charge storage region FD stores electric charge generated by the photoelectric converter 12. The wire connects the charge storage region FD, the gate electrode of the amplifying transistor 22, and a pixel electrode of the photoelectric converter 12 to one another.

The amplifying transistor 22 has its drain connected to a power wire 32. The power wire 32 is also called "source follower power source". While the imaging device 100A is operating, the power wire 32 supplies a predetermined power supply voltage VDD to each of the pixels 10A. VDD is for example approximately 3.3 V. The amplifying transistor 22 outputs a signal voltage corresponding to the amount of signal charge generated by the photoelectric converter 12. The amplifying transistor 22 has its source connected to a drain of the address transistor 24.

To a source of the address transistor 24, a vertical signal line 35 is connected. As illustrated, vertical signal lines 35 are provided separately for each of the columns of the plurality of pixels 10A. To each of the vertical signal lines 35, a load circuit 42 and a column signal processing circuit 44 are connected. The load circuit 42 constitutes a source follower circuit together with the amplifying transistor 22. The column signal processing circuit 44 is also called "row signal accumulation circuit". The load circuit 42 and the column signal processing circuit 44 may be part of the aforementioned peripheral circuit 40.

To a gate electrode of the address transistor 24, an address signal line 34 is connected. Address signal lines 34 are provided separately for each of the rows of the plurality of pixels 10A. The address signal lines 34 are connected to the vertical scanning circuit 46.

The vertical scanning circuit 46 applies a row selection signal to an address signal line 34. The row selection signal controls the turning on and turning off of the address transistor 24. As a result of this, the row to be read out is scanned in a vertical direction, i.e. a column-wise direction, so that the row to be read out is selected.

The vertical scanning circuit 46 controls the turning on and turning off of the address transistors 24 via the address signal lines 34. This allows the vertical scanning circuit 46 to read out an output from the amplifying transistor 22 of a selected pixel 10A to a corresponding vertical signal line 35. The placement of an address transistor 24 is not limited to the example shown in Fig. 2, but may be between the drain of the amplifying transistor 22 and the power wire 32.

Column signal processing circuits 44 are provided separately for each of the columns of the plurality of pixels 10A. A plurality of the column signal processing circuits 44 are associated in one-to-one correspondence with a plurality of the vertical signal lines 35. A signal voltage is applied from a pixel 10A to a vertical signal line 35 via an address transistor 24. The signal voltage is inputted from the vertical signal line 35 to a column signal processing circuit 44 corresponding to the vertical signal line 35.

The column signal processing circuit 44 carries out noise suppression signal processing, analog-to-digital conversion (AD conversion), or other processes. The noise suppression signal processing is for example correlated double sampling. The column signal processing circuit 44 is connected to the horizontal signal readout circuit 48. The horizontal signal readout circuit 48 reads out signals in sequence from a plurality of the column signal processing circuits 44 to a horizontal common signal line 49.

A drain of the reset transistor 26 is part of the charge storage node ND. To a gate of the reset transistor 26, a reset signal line 36 is connected. The reset signal line 36 is connected to the vertical scanning circuit 46.

As with the address signal lines 34, reset signal lines 36 are provided separately for each of the rows of the plurality of pixels 10A. The vertical scanning circuit 46 applies a row selection signal to an address signal line 34. This allows the vertical scanning circuit 46 to select, on a row-by-row basis, pixels 10A to be reset. Further, the vertical scanning circuit 46 applies a reset signal to a gate electrode of a reset transistor 26 via a reset signal line 36. The reset signal controls the turning on and turning off of the reset transistor 26. The vertical scanning circuit 46 allows a reset transistor 26 of a selected row to be turned on by the reset signal. The turning on of the reset transistor 26 causes the potential of the charge storage node ND to be reset.

In this example, feedback lines 53 are provided separately for each of the columns of the plurality of pixels 10A. The reset transistor 26 has its source connected to one of those feedback lines 53. A voltage of the feedback line 53 is supplied to the charge storage node ND as a reset voltage that initializes the electric charge of the photoelectric converter 12.

In this example, inverting amplifiers 50 are provided separately for each of the columns of the plurality of pixels 10A. A plurality of the inverting amplifiers 50 are associated in one-to-one correspondence with a plurality of the feedback lines 53. The aforementioned feedback line 53 is connected to an output terminal of a corresponding inverting amplifier 50. The inverting amplifier 50 may be part of the aforementioned peripheral circuit 40.

Attention is focused on one of the columns of the plurality of pixels 10A. As illustrated, the inverting amplifier 50 has its inverting input terminal connected to the vertical signal line 35 of the column. Further, the output terminal of the inverting amplifier 50 and one or more pixels 10A belonging to the column are connected to each other via the feedback line 53.

While the imaging device 100A is operating, a predetermined voltage Vref is supplied to a noninverting input terminal of the inverting amplifier 50. The voltage Vref is for example a positive voltage of 1 V or nearly 1 V.

One of the one or more pixels 10A belonging to one column is selected, and the address transistor 24 and the reset transistor 26 are turned on. This may result in the formation of a feedback path through which an output from the pixel 10A is negatively fed back. The formation of the feedback path causes a voltage of the vertical signal line 35 to converge to the input voltage Vref to the noninverting input terminal of the inverting amplifier 50. In this way, the formation of the feedback path causes a voltage of the charge storage node ND to be reset to such a voltage that the voltage of the vertical signal line 35 becomes equal to Vref.

As the voltage Vref, a voltage of arbitrary magnitude falling within a range of a power supply voltage and a ground voltage may be used. The power supply voltage is for example 3.3 V. The ground voltage is 0 V.

The inverting amplifier 50 may be called "feedback amplifier". In this way, the imaging device 100A includes a feedback circuit 16 including the inverting amplifier 50 as part of the feedback path.

As is well known, the turning on or turning off of a transistor entails the generation of thermal noise called "kTC noise". Noise generated by the turning on or turning off of a reset transistor is called "reset noise". Reset noise generated by turning off a reset transistor after resetting the potential of a charge storage region undesirably remains in a charge storage region in which signal charge is yet to be stored.

However, reset noise that is generated by the turning off of a reset transistor can be reduced by using feedback. Details of the suppression of reset noise using feedback are described in International Publication No. 2012/147302, the entire contents of which are hereby incorporated by reference.

In the configuration illustrated in Fig. 2, the formation of the feedback path causes an alternating component of thermal noise to be fed back to the source of the reset transistor 26. In the configuration illustrated in Fig. 2, the feedback path is formed until just before the turning off of the reset transistor 26. This makes it possible to reduce reset noise that is generated by the turning off of the reset transistor 26.

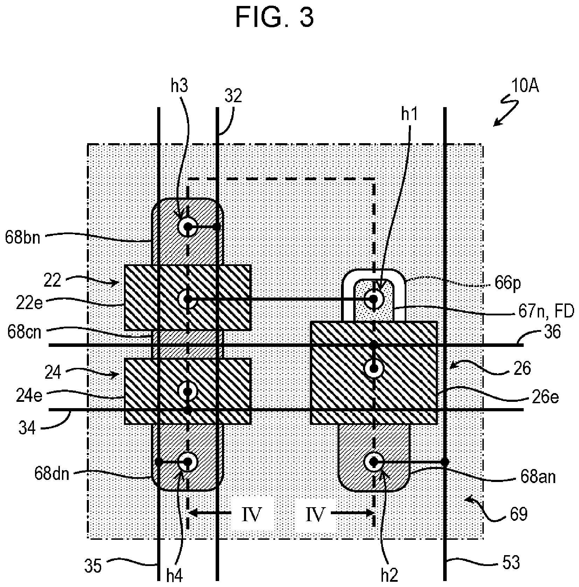

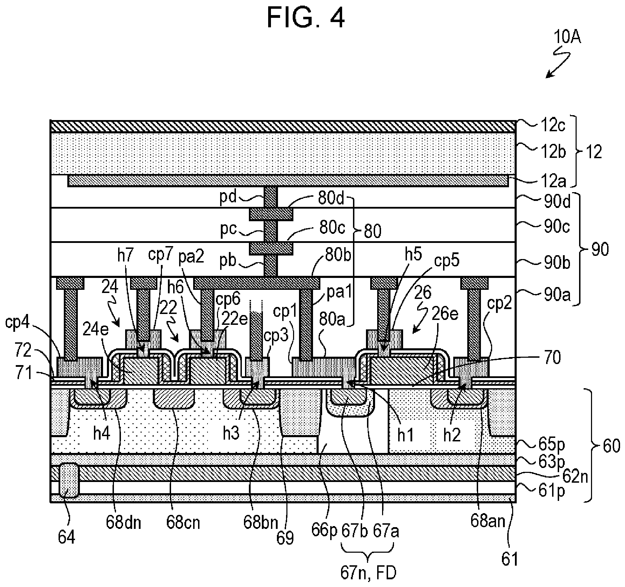

Fig. 3 is a plan view showing an internal layout of a pixel 10A. Fig. 4 is a schematic cross-sectional view of a device structure of the pixel 10A. Fig. 4 is a cross-sectional view of the pixel 10A as taken along line IV-IV in Fig. 3 and expanded in the directions of the arrows.

In the pixel 10A, the semiconductor substrate 60 is provided with a plurality of elements. Fig. 3 schematically shows the arrangement of those elements in plan view. Specifically, Figs. 3 and 4 show an amplifying transistor 22, an address transistor 24, and a reset transistor 26. In Fig. 3, the amplifying transistor 22 and the address transistor 24 are linearly arranged along a vertical direction on the surface of paper.

In the example shown in Figs. 3 and 4, a first diffusion region 67n is an n-type impurity region. The first diffusion region 67n is the drain of the reset transistor 26. Further, the first diffusion region 67n is a charge storage region FD.

As shown in Figs. 3 and 4, the reset transistor 26 includes the first diffusion region 67n as one of the source and the drain. The reset transistor 26 includes a second diffusion region 68an as the other of the source and the drain. The first diffusion region 67n and the second diffusion region 68an are located in the semiconductor substrate. The first diffusion region 67n and the second diffusion region 68an contain an impurity of a first conductivity type. The first conductivity type is hereinafter referred to as "n type". The first diffusion region 67n stores photocharge obtained through conversion carried out by the photoelectric converter 12.

In the present embodiment, the concentration of the n-type impurity in the first diffusion region 67n is lower than the concentration of the n-type impurity in the second diffusion region 68an. Note, however, that the concentration of the n-type impurity in the first diffusion region 67n may be equal to the concentration of the n-type impurity in the second diffusion region 68an. Alternatively, the concentration of the n-type impurity in the first diffusion region 67n may be higher than the concentration of the n-type impurity in the second diffusion region 68an.

The concentrations are described in detail here. In the present embodiment, the first diffusion region 67n has a first portion in which the concentration of the n-type impurity is at its maximum in the first diffusion region 67n. The second diffusion region 68an has a second portion in which the concentration of the n-type impurity is at its maximum in the second diffusion region 68an. In the present embodiment, the concentration of the n-type impurity in the first portion is lower than the concentration of the n-type impurity in the second portion. Note, however, that the concentration of the n-type impurity in the first portion may be equal to the concentration of the n-type impurity in the second portion. Alternatively, the concentration of the n-type impurity in the first portion may be higher than the concentration of the n-type impurity in the second portion.

In the context of the aforementioned magnitude relationship of concentration between the first diffusion region 67n and the second diffusion region 68an, the term "reset transistor 26" may be read as "first transistor". The term "first diffusion region 67n" may be read as "charge storage region FD". The term "n-type impurity" may be read as "impurity of the first conductivity type".

The amplifying transistor 22 includes an n-type impurity region 68bn as one of the source and the drain. The amplifying transistor 22 includes an n-type impurity region 68cn as the other of the source and the drain. The address transistor 24 includes the n-type impurity region 68cn as one of the source and the drain. The address transistor 24 includes an n-type impurity region 68dn as the other of the source and the drain.

The concentration of the n-type impurity in the first diffusion region 67n may be lower than the concentration of the n-type impurity in the n-type impurity region 68bn. The concentration of the n-type impurity in the first diffusion region 67n may be equal to the concentration of the n-type impurity in the n-type impurity region 68bn. The concentration of the n-type impurity in the first diffusion region 67n may be higher than the concentration of the n-type impurity in the n-type impurity region 68bn.

The concentration of the n-type impurity in the first diffusion region 67n may be lower than the concentration of the n-type impurity in the n-type impurity region 68cn. The concentration of the n-type impurity in the first diffusion region 67n may be equal to the concentration of the n-type impurity in the n-type impurity region 68cn. The concentration of the n-type impurity in the first diffusion region 67n may be higher than the concentration of the n-type impurity in the n-type impurity region 68cn.

The concentration of the n-type impurity in the first diffusion region 67n may be lower than the concentration of the n-type impurity in the n-type impurity region 68dn. The concentration of the n-type impurity in the first diffusion region 67n may be equal to the concentration of the n-type impurity in the n-type impurity region 68dn. The concentration of the n-type impurity in the first diffusion region 67n may be higher than the concentration of the n-type impurity in the n-type impurity region 68dn.

The concentrations are described in detail here. In the present embodiment, the first diffusion region 67n has a first portion in which the concentration of the n-type impurity is at its maximum in the first diffusion region 67n. The n-type impurity region 68bn has a third portion in which the concentration of the n-type impurity is at its maximum in the n-type impurity region 68bn. The n-type impurity region 68cn has a fourth portion in which the concentration of the n-type impurity is at its maximum in the n-type impurity region 68cn. The n-type impurity region 68dn has a fifth portion in which the concentration of the n-type impurity is at its maximum in the n-type impurity region 68dn.

The concentration of the n-type impurity in the first portion may be lower than the concentration of the n-type impurity in the third portion. The concentration of the n-type impurity in the first portion may be equal to the concentration of the n-type impurity in the third portion. The concentration of the n-type impurity in the first portion may be higher than the concentration of the n-type impurity in the third portion.

The concentration of the n-type impurity in the first portion may be lower than the concentration of the n-type impurity in the fourth portion. The concentration of the n-type impurity in the first portion may be equal to the concentration of the n-type impurity in the fourth portion. The concentration of the n-type impurity in the first portion may be higher than the concentration of the n-type impurity in the fourth portion.

The concentration of the n-type impurity in the first portion may be lower than the concentration of the n-type impurity in the fifth portion. The concentration of the n-type impurity in the first portion may be equal to the concentration of the n-type impurity in the fifth portion. The concentration of the n-type impurity in the first portion may be higher than the concentration of the n-type impurity in the fifth portion.

In the context of the aforementioned magnitude relationship of concentration between the first diffusion region 67n and the n-type impurity regions 68bn, 68cn, and 68dn, the "first diffusion region 67n" may be read as "charge storage region FD". The term "n-type impurity region 68bn" may be read as "first impurity region". The term "n-type impurity region 68cn" may be read as "second impurity region". The term "n-type impurity region 68dn" may be read as "third impurity region". The term "n-type impurity" may be read as "impurity of the first conductivity type".

In the imaging device 100A according to the present embodiment, the semiconductor substrate 60 contains an impurity of a second conductivity type. The second conductivity type is hereinafter referred to as "p type". The second conductivity type has a polarity opposite to the polarity of the first conductivity type.

As schematically shown in Fig. 4, the pixel 10A schematically includes the semiconductor substrate 60, the photoelectric converter 12, and a wiring structure 80. The photoelectric converter 12 is provided above the semiconductor substrate 60. An interlayer insulating layer 90 is provided between the photoelectric converter 12 and the semiconductor substrate 60. The wiring structure 80 is disposed in the interlayer insulating layer 90. The semiconductor substrate 60 is provided with the amplifying transistor 22. The wiring structure 80 includes a structure that electrically connects the amplifying transistor 22 to the photoelectric converter 12.

In this example, the interlayer insulating layer 90 has a stacked structure including four insulating layers 90a, 90b, 90c, and 90d. The wiring structure 80 includes four wiring layers 80a, 80b, 80c, and 80d and plugs pa1, pa2, pb, pc, and pd. Further, the wiring layer 80a includes contact plugs cp1, cp2, cp3, cp4, cp5, cp6, and cp7.

The plug pa1 is disposed between the wiring layers 80a and 80b. The plug pa2 is disposed between the wiring layers 80a and 80b. The plug pb is disposed between the wiring layers 80b and 80c. The plug pc is disposed between the wiring layers 80c and 80d. The plug pd is disposed between the wiring layer 80d and a pixel electrode 12a.

The number of insulating layers in the interlayer insulating layers 90 and the number of wiring layers in the wiring structure 80 are not limited to this example. These numbers may be arbitrarily set.

The photoelectric converter 12 is disposed on top of the interlayer insulating layer 90. The photoelectric converter 12 includes the pixel electrode 12a, a transparent electrode 12c, and a photoelectric conversion layer 12b. The pixel electrode 12a is provided on top of the interlayer insulating layer 90. The transparent electrode 12c faces the pixel electrode 12a. The photoelectric conversion layer 12b is disposed between the pixel electrode 12a and the transparent electrode 12c.

The photoelectric conversion layer 12b is supported by the semiconductor substrate 60. The photoelectric conversion layer 12b is made, for example, of an organic material or an inorganic material. An example of the organic material is amorphous silicon. The photoelectric conversion layer 12b may include a layer composed of the organic material and a layer composed of the inorganic material.

Light is incident on the photoelectric conversion layer 12b via the transparent electrode 12c. The photoelectric conversion layer 12b converts the incident light into electric charge. This causes positive and negative charge to be generated. The photoelectric conversion layer 12b is typically provided over the plurality of pixels 10A.

The transparent electrode 12c is made of a transparent conducting material. An example of the transparent conducting material is ITO (indium tin oxide).

The transparent electrode 12c is disposed closer to a photosensitive surface than the photoelectric conversion layer 12b. As with the photoelectric conversion layer 12b, the transparent electrode 12c is typically provided over the plurality of pixels 10A. Note, however, that the transparent electrode 12c of each of the pixels 10A may be electrically isolated from that of the other of the pixels 10A by being spatially isolated from each other.

Although not illustrated in Fig. 4, the transparent electrode 12c is connected to the storage control line 39. While the imaging device 100A is operating, the potential of the storage control line 39 is controlled so that a potential difference is generated between the transparent electrode 12c and the pixel electrode 12a. As a result of this, signal charge generated by photoelectric conversion can be collected by the pixel electrode 12a.

For example, the potential of the storage control line 39 is controlled so that the potential of the transparent electrode 12c becomes higher than the potential of the pixel electrode 12a. Specifically, a positive voltage of, for example, approximately 10 V is applied to the storage control line 39. As a result of this, the hole of a hole-electron pair generated in the photoelectric conversion layer 12b can be collected by the pixel electrode 12a.

The signal charge collected by the pixel electrode 12a is stored in the first diffusion region 67n via the wiring structure 80. As mentioned above, the first diffusion region 67n corresponds to the charge storage region FD.

The pixel electrode 12a is made of metal, a metal nitride, polysilicon, or other substances. Examples of the metal include aluminum and copper. As the polysilicon, polysilicon given electrical conductivity by being doped with an impurity can be employed.

The pixel electrode 12a is spatially isolated from the pixel electrode 12a of another adjacent pixel 10A. This causes the pixel electrode 12a to be electrically isolated from the pixel electrode 12a of another pixel 10A.

The semiconductor substrate 60 includes a support substrate 61 and at least one semiconductor layer. The at least one semiconductor layer is provided on top of the support substrate 61. An example of the support substrate 61 here is a p-type silicon (Si) substrate.

In this example, the semiconductor substrate 60 includes a p-type semiconductor layer 61p, an n-type semiconductor layer 62n, a p-type semiconductor layer 63p, and a p-type semiconductor layer 65p. The p-type semiconductor layer 61p is provided on top of the support substrate 61. The n-type semiconductor layer 62n is provided on top of the p-type semiconductor layer 61p. The p-type semiconductor layer 63p is provided on top of the n-type semiconductor layer 62n. The n-type semiconductor layer 65p is provided on top of the p-type semiconductor layer 63p.

The p-type semiconductor layer 63p is provided all over the support substrate 61. The p-type semiconductor layer 65p has a p-type impurity region 66p, the first diffusion region 67n, the second diffusion region 68an, the n-type impurity regions 68bn, 68cn, and 68dn, and an element isolation region 69. The concentration of an impurity in the p-type impurity region 66p is lower than the concentration of an impurity in the p-type semiconductor layer 65p. The first diffusion region 67n is provided in the p-type impurity region 66p.

In a typical example, a semiconductor layer is formed by epitaxial growth. Then, ion implantation of an impurity into the semiconductor layer thus formed is carried out. In this way, the p-type semiconductor layer 61p, the n-type semiconductor layer 62n, the p-type semiconductor layer 63p, and the p-type semiconductor layer 65p are each formed.

The impurity concentrations in the p-type semiconductor layer 63p and the p-type semiconductor layer 65p are about equal to each other. The impurity concentrations in the p-type semiconductor layer 63p and the p-type semiconductor layer 65p are higher than the impurity concentration of the p-type semiconductor layer 61p.

The n-type semiconductor layer 62n is disposed between the p-type semiconductor layer 61p and the p-type semiconductor layer 63p. The n-type semiconductor layer 62n reduces the inflow of a small number of carriers from the support substrate 61 or the peripheral circuit 40 into the first diffusion region 67n, i.e. the charge storage region FD. In the present embodiment, the signal charge is a hole.

While the imaging device 100A is operating, the potential of the n-type semiconductor layer 62n is controlled via a well contact provided outside the imaging region R1. For the imaging region R1, refer to Fig. 1. The well contact is not illustrated.

In this example, the semiconductor substrate 60 has a p-type region 64. The p-type region 64 is provided between the p-type semiconductor layer 63p and the support substrate 61 so as to pass completely through the p-type semiconductor layer 61p and the n-type semiconductor layer 62n. The p-type region 64 has a higher impurity concentration than the p-type semiconductor layer 63p and the p-type semiconductor layer 65p. The p-type region 64 electrically connects the p-type semiconductor layer 63p to the support substrate 61.

While the imaging device 100A is operating, the potentials of the p-type semiconductor layer 63p and the support substrate 61 are controlled vis a substrate contact provided outside the imaging region R1. The p-type semiconductor layer 65p is provided so as to touch the p-type semiconductor layer 63p. This makes it possible to control the potential of the p-type semiconductor layer 65p via the p-type semiconductor layer 63p while the imaging device 100A is operating. The substrate contact is not illustrated.

The semiconductor substrate 60 is provided with the amplifying transistor 22, the address transistor 24, and the reset transistor 26. The reset transistor 26 includes the first diffusion region 67n, the second diffusion region 68an, part of an insulating layer 70, and a gate electrode 26e. The insulating layer 70 is provided on top of the semiconductor substrate 60. The gate electrode 26e is provided on top of the insulating layer 70.

The first diffusion region 67n and the second diffusion region 68an function as the drain and source, respectively, of the reset transistor 26. The first diffusion region 67n functions as the charge storage region FD, in which signal charge generated by the photoelectric converter 12 is temporarily stored.

The amplifying transistor 22 includes the n-type impurity region 68bn, the n-type impurity region 68cn, part of the insulating layer 70, and a gate electrode 22e. The gate electrode 22e is provided on top of the insulating layer 70. The n-type impurity regions 68bn and 68cn function as the drain and source, respectively, of the amplifying transistor 22.

The element isolation region 69 is disposed between the n-type impurity region 68bn and the first diffusion region 67n. The element isolation region 69 is for example a p-type impurity diffusion region. The element isolation region 69 causes the amplifying transistor 22 and the reset transistor 26 to be electrically isolated from each other.

As schematically shown in Fig. 4, the first diffusion region 67n is provided in the p-type impurity region 66p. As a result of this, the first diffusion region 67n and the element isolation region 69 do not touch each other.

Suppose, for example, a case where a p-type impurity layer is used as the element isolation region 69. When the first diffusion region 67n and the element isolation region 69 touch each other, both the p-type impurity concentration and the n-type impurity concentration at the junction are high. Therefore, a leak current attributed to this high junction concentration tends to occur around the junction between he first diffusion region 67n and the element isolation region 69.

On the other hand, in the example shown in Fig. 4, the first diffusion region 67n and the element isolation region 69 are disposed so as not to touch each other. As a result of this, even when a high-concentration p-type impurity layer is used as the element isolation region 69, the rise in p-n junction concentration can be curbed, so that the leak current can be reduced.

STI (shallow trench isolation) can be used as the element isolation region 69. In a case where STI is used too, the first diffusion region 67n and the STI may be disposed so as not to touch each other. As a result of this, a leak current attributed to a crystal defect in an STI side wall portion may be reduced.

The element isolation region 69 is also provided between pixels 10A adjacent to each other, and electrically isolates the signal detection circuits 14 of these pixels 10A from each other. The element isolation region 69 may be provided around a pair of the amplifying transistor 22 and the address transistor 24. Further, the element isolation region 69 may be provided around the reset transistor 26.

The address transistor 24 includes the n-type impurity region 68cn, the n-type impurity region 68dn, part of the insulating layer 70, and a gate electrode 24e. The gate electrode 24e is provided on top of the insulating layer 70.

In this example, the address transistor 24 shares the n-type impurity region 68cn with the amplifying transistor 22. As a result of this, the address transistor 24 is electrically connected to the amplifying transistor 22. The n-type impurity region 68cn functions as the drain of the address transistor 24. The n-type impurity region 68dn functions as the source of the address transistor 24.

In this example, an insulating layer 72 is provided so as to cover the gate electrode 26e of the reset transistor 26, the gate electrode 22e of the amplifying transistor 22, and the gate electrode 24e of the address transistor 24. The insulating layer 72 is for example a silicon oxide film. The insulating layer 72 may have a stacked structure including a plurality of insulating layers.

In this example, furthermore, an insulating layer 71 is interposed between the insulating layer 72 and the gate electrodes 26e, 22e, and 24e. The insulating layer 71 is for example a silicon oxide film. The insulating layer 71 may have a stacked structure including a plurality of insulating layers.

In the present embodiment, the area of the gate electrode 22e of the amplifying transistor 22 in plan view is smaller than the area of the gate electrode 26e of the reset transistor 26 in plan view. Note, however, that the area of the gate electrode 22e in plan view may be equal to the area of the gate electrode 26e in plan view. Alternatively, the area of the gate electrode 22e in plan view may be larger than the area of the gate electrode 26e in plan view.

A portion of the insulating layer 70 between the gate electrode 22e and the semiconductor substrate 60 functions as a gate insulating film of the amplifying transistor 22. A portion of the insulating layer 70 between the gate electrode 24e and the semiconductor substrate 60 functions as a gate insulating film of the address transistor 24. A portion of the insulating layer 70 between the gate electrode 26e and the semiconductor substrate 60 functions as a gate insulating film of the reset transistor 26. The insulating layer 70 may be an oxide. A gate insulating film that is an oxide may be referred to as "gate oxide film".

The stacked structures of the insulating layers 72 and 71 have a plurality of contact holes. In this example, the insulating layers 72 and 71 are provided with contact holes h1 to h7.

The contact holes h1, h2, h3, and h4 are provided in positions overlapping the first diffusion region 67n, the second diffusion region 68an, the n-type impurity region 68bn, and the n-type impurity region 68dn, respectively. In the positions of the contact holes h1, h2, h3, and h4, the contact plugs cp1, cp2, cp3, and cp4 are disposed, respectively.

The contact holes h5, h6, and h7 are provided in positions overlapping the gate electrodes 26e, 22e, and 24e, respectively. In the positions of the contact holes h5, h6, and h7, the contact plugs cp5, cp6, and cp7 are disposed, respectively.

In the configuration illustrated in Fig. 4, the wiring layer 80a includes the contact plugs cp1 to cp7. Typically, the wiring layer 80a is a polysilicon layer doped with an n-type impurity. The wiring layer 80a is disposed closest to the semiconductor substrate 60 of the wiring layers included in the wiring structure 80. The wiring layer 80b, the plug pa1, and the plug pa2 are disposed in the insulating layer 90a.

The first diffusion region 67n, the contact plug cp1, the plug pa1, the wiring layer 80b, the plug pa2, the contact plug cp6, and the gate electrode 22e of the amplifying transistor 22 are electrically connected to one another in this order. For this reason, electric charge may be sent from the first diffusion region 67n to the gate electrode 22e.

The wiring layer 80b is disposed in the insulating layer 90a. The wiring layer 80b may include the vertical signal line 35, the address signal line 34, the power wire 32, the reset signal line 36, and the feedback line 53, or other lines or wires as part thereof.

The vertical signal line 35 is connected to the n-type impurity region 68dn via the contact plug cp4. The address signal line 34 is connected to the gate electrode 24e via the contact plug cp7. The power wire 32 is connected to the n-type impurity region 68bn via the contact plug cp3. The reset signal line 36 is connected to the gate electrode 26e via the contact plug cp5. The feedback line 53 is connected to the second diffusion region 68an via the contact plug cp2. It should be noted that Fig. 4 omits to illustrate part of a plug connected to the contact plug cp3.

The plug pb is disposed in the insulating layer 90b. The plug pb connects the wiring layer 80b to the wiring layer 80c. The plug pc is disposed in the insulating layer 90c. The plug pc connects the wiring layer 80c to the wiring layer 80d. The plug pd is disposed in the insulating layer 90d. The plug pd connects the wiring layer 80d to the pixel electrode 12a.

The wiring layers 80b to 80d and the plugs pa1, pa2, and pb to pd are typically made of metal, a metal compound, or other substances. Examples of the metal include copper and tungsten. Examples of the metal compound include a metal nitride and a metal oxide.

The semiconductor substrate 60 is provided with a signal detection circuit 14. The plugs pa1, pa2, and pb to pd, the wiring layers 80b to 80d, and the contact plugs cp1 and cp6 electrically connect the photoelectric converter 12 to the signal detection circuit 14.

Attention is focused here on an n-type impurity region provided in the semiconductor substrate 60. In the illustrated example, the p-type semiconductor layer 65p is provided as a p well. The p-type impurity region 66p is provided in the p-type semiconductor layer 65p. The first diffusion region 67n is provided in the p-type impurity region 66p. The first diffusion region 67n is provided near a surface of the semiconductor substrate 60. At least part of the first diffusion region 67n is located at the surface of the semiconductor substrate 60.

In the configuration illustrated in Fig. 4, the first diffusion region 67n includes a first region 67a and a second region 67b. The first region 67a is lower in impurity concentration than the second diffusion region 68an and the n-type impurity regions 68bn to 68dn. The second region 67b is provided in the first region 67a. The second region 67b has a higher impurity concentration than the first region 67a.

The contact hole h1 is located on top of the second region 67b. The contact plug cp1 is connected to the second region 67b via the contact hole h1.

As mentioned above, disposing the p-type semiconductor layer 65p adjacent to the p-type semiconductor layer 63p makes it possible to control the potential of the p-type semiconductor layer 65p via the p-type semiconductor layer 63p while the imaging device 100A is operating. The employment of such a configuration makes it possible to dispose, around a contact portion between the contact plug cp1 and the semiconductor substrate 60, a low-concentration region that is relatively low in impurity concentration. The aforementioned contact portion is specifically a contact portion between the contact plug cp1 and the second region 67b. The aforementioned low-concentration region is specifically the first region 67a and the p-type impurity region 66p.

It is not essential to provide the second region 67b in the first diffusion region 67n. However, making the impurity concentration of the second region 67b, which is the contact portion between the contact plug cp1 and the semiconductor substrate 60, comparatively high makes it possible to reduce the spread of a depletion layer around the contact portion. By thus reducing depletion around the portion in which the contact plug cp1 and the semiconductor substrate 60 make contact with each other, a leak current attributed to a crystal defect in the semiconductor substrate 60 at the interface between the contact plug cp1 and the semiconductor substrate 60 may be reduced. Further, by connecting the contact plug cp1 to the second region 67b, which has a comparatively high impurity concentration, a reduction in contact resistance can be achieved.

Further, in this example, the first region 67a is interposed between the second region 67b of the first diffusion region 67n and the p-type impurity region 66p. The impurity concentration of the first region 67a is lower than the impurity concentration of the second region 67b. The first region 67a is also interposed between the second region 67b of the first diffusion region 67n and the p-type semiconductor layer 65p. By disposing the first region 67a, which is relatively low in impurity concentration, around the second region 67b, the intensity of an electric field that is formed by a p-n junction between the first diffusion region 67n and the p-type semiconductor layer 65p or the p-type impurity region 66p may be lessened. This lessening of the intensity of an electric field reduces a leak current attributed to an electric field that is formed by a p-n junction.

The following further describes the imaging device with reference to radiation.

Exposure of the imaging device to radiation may cause a dark current to increase. It is conceivable that a dark current may increase, for example, in the following way.

That is, exposure of the semiconductor substrate of the imaging device to radiation may disturb the crystallinity of the semiconductor substrate. For example, in a case where the semiconductor substrate is a silicon substrate, exposure of the silicon substrate to radiation may disturb the crystallinity of silicon. Disturbance of crystallinity in a region of the semiconductor substrate in which electric charge is stored causes a dark current to increase.

In the semiconductor substrate, a photodiode may be constituted. A photodiode may be constituted by a junction between p-type and n-type regions of the silicon substrate. PTLs 1 and 2 each involve the use of a photodiode.

The photodiode plays a role in storing electric charge generated by the photodiode. For this reason, from the point of view of reducing a dark current, it is conceivable that the photodiode may be made smaller. Note, however, that it is important for the photodiode to play a role in photoelectric conversion that converts light into electric charge. Therefore, from the point of view of securing the photoelectric conversion function and achieving the required photoelectric conversion efficiency, it is not easy to make the photodiode smaller.

On the other hand, a stacked imaging device has a photoelectric conversion layer disposed above a semiconductor substrate. The semiconductor substrate is provided with a charge storage region. In the photoelectric conversion layer, light is converted into electric charge. This electric charge is sent to the charge storage region via an electric pathway. In the stacked imaging device, the photoelectric conversion layer and the charge storage region are elements that are separate from each other. This makes it possible to, while ensuring the photoelectric conversion function by increasing the area of the photoelectric conversion layer in plan view, reduce a dark current by reducing the area of the charge storage region in plan view, i.e. to ensure radiation resistance while ensuring the photoelectric conversion function.

It should be noted that an imaging device including a photodiode as a photoelectric converter may include a charge storage region together with the photodiode. In such an imaging device, reducing the area of the charge storage region in plan view only brings about a limited dark current reduction effect. A reason for this is that even with a smaller charge storage region, the large photodiode makes it hard to reduce the total area of regions in which electric charge is stored. On the other hand, in the stacked imaging device, reducing the area of the charge storage region in plan view brings about a favorably improved dark current reduction effect, i.e. brings about favorable improvement in radiation resistance.

The inventors conducted experiments according to Examples 1 to 3 to quantitatively determine the appropriate area of a charge storage region in plan view.

[Example 1]

An imaging device of Example 1 corresponds to the imaging device of Fig. 1 to 4. Specifically, the imaging device of Example 1 has a plurality of pixels constituting a pixel array. The total pixel count is $3.02 \times 10^5$. Each of the pixels has the shape of a square measuring 3 $\mu$m long by 3 $\mu$m wide and having an area of 9 $\mu m^2$ in plan view. A photoelectric conversion layer is provided across all pixels in plan view. The photoelectric conversion layer is made of an organic material. The photoelectric conversion layer has a thickness of 1000 nm. A semiconductor substrate is a silicon substrate. The deemed area of a charge storage region in plan view is 0.0064 $\mu m^2$. The term "deemed area" will be described later.

In Example 1, the rate of deterioration of the pixel array by irradiation of the imaging device with proton beams with a dose of $1 \times 10^{10}$ p/cm$^2$ at 70 MeV was evaluated. Specifically, the flux of proton beams is $1 \times 10^6$ p/cm$^2$/sec. The time of irradiation with proton beams is 10000 seconds. That is, the dose of proton beams is $1 \times 10^6$ p/cm$^2$/sec $\times$ 10000 sec = $1 \times 10^{10}$ p/cm$^2$. As an irradiation source of proton beams, a proton accelerator installed in a cyclone facility of the National Institute of Radiological Sciences was used. Specifically, this proton accelerator is present in the cyclone facility of the National Institute of Radiological Sciences as of January 2020.

It should be noted that in the aforementioned context, the dose is specifically fluence. In the following, the wording "dose (fluence)" may be used. Note here that the letter "p" of $1 \times 10^{10}$ p/cm$^2$ and $1 \times 10^6$ p/cm$^2$/sec is not "pico". The dose of proton beams of $1 \times 10^{10}$ p/cm$^2$ means that $1 \times 10^{10}$ proton beams are incident per square centimeter. The flux of proton beams of $1 \times 10^6$ p/cm$^2$/sec means that $1 \times 10^6$ proton beams are incident per square centimeter and per second.

There are various types of radiation such as $\alpha$-rays, $\beta$-rays, $\gamma$-rays, X-rays, neutron beams, and proton beams. Radiation induces different chemical reactions depending on the type of particle and electromagnetic wave that constitutes the radiation. However, it is not realistic to conduct experiments on irradiation with all types of radiation. In Example 1, the imaging device was irradiated with proton beams. Proton beams are hardly blocked by a shield, such as a metal plate or glass, that the imaging device may have. In this respect, an experiment on irradiation with proton beams is significant.

Radiation induces different chemical reactions depending on the amount of energy that the radiation has. In Example 1, the imaging device was irradiated with proton beams at 70 MeV. The amount of energy of 70 MeV is the amount of energy that particle beams may have in outer space. In this respect, the amount of energy of 70 MeV is significant.

A ten years' worth of dose predicted from the distribution number of protons that may be complimented in a low orbit that an artificial satellite may take is approximately $1 \times 10^{10}$ p/cm$^2$. Ten years is an example of the life of an artificial satellite. In a low orbit, an aerospace artificial satellite may fly. Further, the artificial satellite may be mounted with an imaging device. In this respect, the dose of $1 \times 10^{10}$ p/cm$^2$ is significant. An imaging device mounted in an artificial satellite that flies in a low orbit may be exposed to proton beams regardless of the presence or absence of the taking of an image or the presence or absence of the turning on of the power.

In Example 1, the number of pixels with increased dark currents was counted after irradiation with proton beams. Whether the dark currents had increased was determined according to whether the potentials of the respective source followers of the pixels were high when signals from the respective pixels in the imaging region were read out with the imaging device placed in a completely dark place. The potentials of the source followers correspond to the potentials of the vertical signal lines 35 of Fig. 1.

A reference potential is described here. The imaging device has a region that is not irradiated with light. The region is provided with a reference pixel. The reference pixel at least partially shares a common configuration with a pixel of the imaging region. The reference potential is the potential of the source follower of the reference pixel, and corresponds to the potential of a vertical signal line connected to the reference pixel.

The region that is not irradiated with light may be referred to as "optical black region". The reference pixel may be referred to as "optical black pixel". The reference potential may be used as a reference signal. Specifically, the potential of the source follower of a pixel in the imaging region at the time when a signal from the pixel is read out with the imaging device placed in a completely dark place is defined as "dark potential". At this point in time, in a case where the dark potential is higher than the reference potential, such an explanation is given that the pixel has a white spot. Meanwhile, in a case where the dark potential is lower than the reference potential, such an explanation is given that the pixel has a black spot. A white spot and a black spot cause noise.

In the following, a pixel with an increased dark current may be referred to as "failed pixel". The number of failed pixels may be referred to as "failed pixel count".

Further, in Example 1, the ratio of the failed pixel count to the total pixel count was calculated by dividing the failed pixel count by the total pixel count. In the following, this ratio may be referred to as "pixel failure probability". The pixel failure probability may be an index of the rate of deterioration of the pixel array.

[Example 2]

The time of irradiation of the imaging device with proton beams was changed to 5000 seconds. That is, the dose of proton beams to the imaging device was changed to $5 \times 10^9$ p/cm$^2$. Except that, an experiment on irradiation was conducted in the same manner as in Example 1. After that, the failed pixel count was counted, and the pixel failure probability was calculated.

[Example 3]

The time of irradiation of the imaging device with proton beams was changed to 1000 seconds. That is, the dose of proton beams to the imaging device was changed to $1 \times 10^9$ p/cm$^2$. Except that, an experiment on irradiation was conducted in the same manner as in Example 1. After that, the failed pixel count was counted, and the pixel failure probability was calculated.

Experimental results of Examples 1, 2, and 3 are tabulated in Table 1.

[Table 1]

|  | Dose (p/cm$^2$) | Failed pixel count | Pixel failure probability |
|---|---|---|---|
| Example 1 | $1 \times 10^{10}$ | 174 | $5.76 \times 10^{-4}$ |
| Example 2 | $5 \times 10^9$ | 37 | $1.23 \times 10^{-4}$ |
| Example 3 | $1 \times 10^9$ | 0 | 0 |

Ideally, it is preferable that the imaging device be free of such defects that signals can no longer be read out from pixels. However, in actuality, there may occur such a situation in which signals can no longer be read out from some pixels of the pixel array. Such a situation may arise due to adhesion of foreign matter in the process of manufacture of the imaging device. Such a situation may arise due to adhesion of dirt and dust to lenses, optical components, or other components, scratches on those components, or other flaws in those components. Such a situation may arise due to impurities in a silicon substrate. Such a situation may arise due to aged deterioration in signal quality.

In preparation for a situation in which there occurs such a defective pixel from which a signal can no longer be read out, an actual imaging device may be provided with a correction function. The correction function makes it possible to estimate information on the defective pixel on the basis of information on a normal pixel adjacent to the defective pixel. Estimating the information on the defective pixel by the correction function makes it possible to reduce deterioration in quality of an image that is outputted from the imaging device.

The correction function easily exerts an image quality deterioration reduction effect in a case where failed pixels do not concentrate in one place. Further, this effect is easily exerted in a case where the ratio of the failed pixel count to the total pixel count, i.e. the pixel failure probability, is low. The capability of the correction function may depend on the subsequent system, the memory capacity, or other factors.

Exposure of the imaging device to radiation causes failed pixels to randomly occur in the pixel array. For this reason, radiation hardly causes failed pixels to occur concentratedly in one place. Meanwhile, depending on the configuration of the pixels, exposure of the imaging device to radiation may cause a large number of failed pixels to occur in the pixel array. For this reason, it is desirable to an imaging device that is used under an environment exposed to radiation that pixels be configured so that the failed pixel count is low.

The inventors assumed that the pixel failure probability depends on the area of a charge storage region in a semiconductor substrate in plan view. Specifically, the inventors modeled the pixel failure probability according to Formula 1 as follows:

$$\text{Formula 1: } d/N = (F \times t \times S) \times P \times (1 - P)^{(F \times t \times S) - 1}$$

In Formula 1, d is the failed pixel count. N is the total pixel count. That is, d/N is the pixel failure probability. F is the flux of proton beams. t is the time of irradiation with proton beams. That is $F \times t$ is the dose (fluence) of proton beams. S is the area of the charge storage region in plan view. P is a collision probability. The formula is based on the assumption that the pixel failure probability conforms to a negative binominal distribution.

The aforementioned Examples 1 to 3 are equal in terms of the total pixel count N, the flux F, the area S of the charge storage region in plan view. Meanwhile, they are different in terms of the time of irradiation t and the failed pixel count d. Data from such Examples 1 to 3 were used to perform theoretical fitting of Formula 1 by the method of least squares, whereby the collision probability P was obtained. The collision probability P thus obtained is $8.0 \times 10^{-4}$. It should be noted that this theoretical fitting involved the use of the deemed area of the charge storage region in plan view as the area S of the charge storage region in plan view.

$F = 1 \times 10^6$ p/cm$^2$/sec, t = 10000 sec, and $P = 8.0 \times 10^{-4}$ were substituted in Formula 1. This turns the right side of Formula 1 into a function of S. That is, a relational expression between the pixel failure probability d/N and the area S of the charge storage region in plan view is obtained. In the following, this relational expression may be referred to as "specific relational expression".

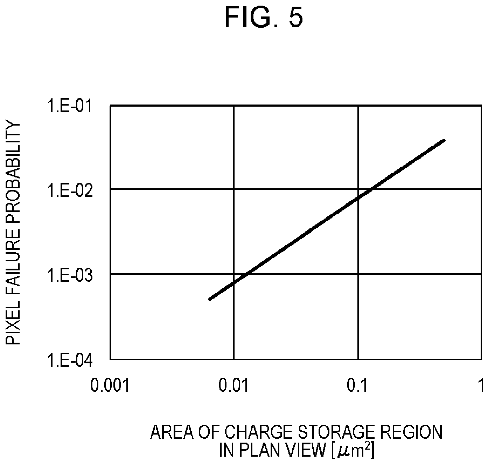

Fig. 5 shows the specific relational expression in graph form. That is, Fig. 5 is a graph showing a relationship between the area S of the charge storage region in plan view and the pixel failure probability d/N. In Fig. 5, the vertical and horizontal axes are logarithmic axes. In this log-log graph. the relationship between the area S of the charge storage region in plan view and the pixel failure probability d/N exhibits a substantially linear shape.

Consider here making the pixel failure probability d/N lower than or equal to $3.2 \times 10^{-3}$, i.e. lower than or equal to 0.32%. Achieving such a pixel failure probability d/N is equivalent to keeping the failed pixel count lower than or equal to 32 in a case where the total pixel count is 10000. According to the specific relational expression, when the pixel failure probability d/N is lower than or equal to $3.2 \times 10^{-3}$, the area S of the charge storage region in plan view is smaller than or equal to 0.04 $\mu$m$^2$.

Further, consider making the pixel failure probability d/N lower than or equal to $2.7 \times 10^{-3}$, i.e. lower than or equal to 0.27%. Achieving such a pixel failure probability d/N is equivalent to keeping the failed pixel count lower than or equal to 1 in a case where the total pixel count is 370. According to the specific relational expression, when the pixel failure probability d/N is lower than or equal to $2.7 \times 10^{-3}$, the area S of the charge storage region in plan view is smaller than or equal to 0.034 $\mu$m$^2$. It should be noted that assuming that failed pixels randomly occur and the probability of occurrence of failed pixels conforms to a normal distribution, the aforementioned value falls within $3\sigma$ and satisfies a general quality control standard index. $\sigma$ represents a standard deviation.

Further, consider making the pixel failure probability d/N lower than or equal to $8.0 \times 10^{-4}$, i.e. lower than or equal to 0.08%. According to the specific relational expression, when the pixel failure probability d/N is lower than or equal to $8.0 \times 10^{-4}$, the area S of the charge storage region in plan view is smaller than or equal to 0.01 $\mu$m$^2$. In a case where the imaging device is used for an aerospace purpose, a subject may appear in the distance. In this case, information that one pixel has represents the average brightness of a wide area. In this case, improving the reliability of one piece of pixel information leads directly to improving the accuracy of information obtained by imaging. From the point of view of improving the accuracy of information obtained by imaging, it is desirable that the number of pixels that are subjected to the aforementioned correction be small. In this case, it is desirable that the pixel failure probability d/N be reduced to the aforementioned extent.

As can be understood from the foregoing description, values of, for example, 0.04 $\mu$m$^2$, 0.034 $\mu$m$^2$, and 0.01 $\mu$m$^2$ can be employed as upper limits on the area S of the charge storage region in plan view. Dividing these values by

the area 9 $\mu$m$^2$ of the pixel in plan view gives ratios $4.4 \times 10^{-3}$, $3.8 \times 10^{-3}$, and $1.1 \times 10^{-3}$, respectively. Employing the aforementioned values as upper limits on the ratio of the area S of the charge storage region in plan view to the area of the pixel in plan view too may contribute to ensuring the radiation resistance of the imaging device.

In Examples 1, 2, and 3, the pixel failure probability d/N is lower than $3.2 \times 10^{-3}$, $2.7 \times 10^{-3}$, or $8.0 \times 10^{-4}$. Incorporating the correction function into the imaging device of Examples 1 to 3 is considered to make it possible to ensure the quality of an image that is outputted from the imaging device.

The deemed area of the charge storage region in plan view is described here. The charge storage region of Examples 1 to 3 is formed by implanting impurities into the semiconductor substrate through an opening of a mask. The deemed area of the charge storage region in plan view is the area of the opening of the mask.

Specifically, the opening of the mask used in forming the charge storage region of Examples 1 to 3 has the shape of a square measuring 0.08 $\mu$m long by 0.08 $\mu$m wide in plan view. Therefore, the area of the charge storage region of Examples 1 to 3 is 0.08 $\mu$m $\times$ 0.08 $\mu$m = 0.0064 $\mu$m$^2$.

In actuality, the impurities implanted into the semiconductor substrate may diffuse later. For example, in the manufacture of the imaging device, the step of heating the semiconductor substrate is executed after the step of implanting the impurities into the semiconductor substrate. This heating step may cause the impurities to diffuse.

Note, however, that there is a correlation between the area of the opening of the mask and the actual area of the charge storage region in plan view. For this reason, making the actual area of the charge storage region in plan view smaller than or equal to S, which is derived by the aforementioned specific relational formula, may contribute to reducing a dark current. In a typical example, the actual area of the charge storage region in plan view is close to the area of the opening of the mask to some extent.

In Examples 1 to 3, upper limits on the area of the charge storage region in plan view have been discussed on the basis of the experiments on irradiation of the imaging device with proton beams. However, according to these upper limits, improvement in resistance of the imaging device against not only proton beams but also other types of radiation such as neutron beams is expected.

In Examples 1 to 3, the photoelectric conversion layer is made of an organic semiconductor material. That is, the photoelectric conversion function is assigned to the organic semiconductor material. Note, however, that the photoelectric conversion layer may be constituted by a carbon nanotube, a quantum dot, or a nanoparticle.

From the foregoing description, the following imaging device is derived. The following uses terms "first electrode" and "second electrode". The first electrode may correspond to a pixel electrode 12a. The aforementioned features of the pixel electrode 12a are applicable to the first electrode. The second electrode may correspond to a transparent electrode 12c. The aforementioned features of the transparent electrode 12c are applicable to the second electrode.

An imaging device 100A includes a first electrode, a second electrode, a photoelectric conversion layer 12b, and a charge storage region FD. The photoelectric conversion layer 12b is located between the first electrode and the second electrode. The charge storage region FD is electrically connected to the first electrode. This configuration makes it possible to, while ensuring the photoelectric conversion function by increasing the area of the photoelectric conversion layer 12b in plan view, ensure radiation resistance by reducing the area of the charge storage region FD in plan view. Specifically, this configuration makes it possible to reduce the number of pixels with increased dark currents even when the imaging device 100A is exposed to radiation. For this reason, this configuration makes it hard for the quality of an image that is obtained by the imaging device 100A, i.e. image quality, to deteriorate even when the imaging device 100A is exposed to radiation. It should be noted that an imaging device having this configuration may be referred to as "imaging device of a stack structure".

The area of the charge storage region FD in plan view may be smaller than or equal to 0.04 $\mu$m$^2$. Reducing the area of the charge storage region FD in this way makes it hard for image quality to deteriorate even when the imaging device 100A is exposed to radiation.

The area of the charge storage region FD in plan view may be smaller than or equal to 0.034 $\mu$m$^2$, or may be smaller than or equal to 0.01 $\mu$m$^2$. The area of the charge storage region FD in plan view is for example larger than or equal to 0.0001 $\mu$m$^2$. The area of the charge storage region FD in plan view may be larger than or equal to 0.001 $\mu$m$^2$.

It should be noted that the outer edge of the charge storage region FD is defined by a junction. The junction is a portion in which the concentration of an n-type impurity and the concentration of a p-type impurity are equal to each other. Specifically, the outer edge of the charge storage region FD is defined by the junction with no electric field being applied to the charge storage region. The junction may also be referred to as "p-n junction". The junction may be measured using a measuring instrument such as an SCM (scanning capacitance microscopy). The outer edge of another diffusion region is defined in the same way as the outer edge of the charge storage region FD. The area of the charge storage region FD in plan view is based on the outer edge of the charge storage region FD thus defined.

In the configuration shown in Fig. 1, a pixel 10A includes the first electrode, the second electrode, the photoelectric conversion layer 12b, and the charge storage region FD.

In one example, the ratio of the area of the charge storage region FD in plan view to the area of the pixel 10A in plan view is lower than or equal to $4.4 \times 10^{-3}$, i.e. lower than or equal to 0.44%. Reducing the ratio of the area of the charge storage region FD in this way makes it hard for image quality to deteriorate even when the imaging device 100A is exposed to radiation.

The ratio of the area of the charge storage region FD in plan view to the area of the pixel 10A in plan view may be lower than or equal to $3.8 \times 10^{-3}$, i.e. lower than or equal to 0.38%, or may be lower than or equal to $1.1 \times 10^{-3}$, i.e. lower than or equal to 0.11%. This ratio is for example higher than or equal to $1.0 \times 10^{-5}$, i.e. higher than or equal to 0.001%. This ratio may be higher than or equal to $1.0 \times 10^{-4}$, i.e. higher than or equal to 0.01%.

In the imaging region R1 of the example shown in Fig. 1, charge storage regions FD appear for each of given areas in plan view. The ratio of the area of the charge storage region FD in plan view to the given area is lower than or equal to $4.4 \times 10^{-3}$, i.e. lower than or equal to 0.44%. This ratio may be lower than or equal to $3.8 \times 10^{-3}$, i.e. lower than or equal to 0.38%, or may be lower than or equal to $1.1 \times 10^{-3}$, i.e. lower than or equal to 0.11%. This ratio is for example higher than or equal to $1.0 \times 10^{-5}$, i.e. higher than or equal to 0.001%. This ratio may be higher than or equal to $1.0 \times 10^{-4}$, i.e. higher than or equal to 0.01%.

In the imaging region R1 of the example shown in Fig. 1, a plurality of the pixels 10A are configured. In a plan view, the pixels 10A appear separately for each of the given areas. That is, in a plan view, each of the pixels 10A has a given area.

The photoelectric conversion layer 12b may contain an organic material as a major ingredient. Selecting the major ingredient of the photoelectric conversion layer 12b in this way makes it hard for image quality to deteriorate even when the imaging device 100A is exposed to radiation.

Note here that the major ingredient of the photoelectric conversion layer 12b means the ingredient that the photoelectric conversion layer 12b contains with the highest proportion by mass. Assuming that the overall mass of the photoelectric conversion 12b is 100 mass%, the photoelectric conversion layer 12b may contain 50 mass% or more of an organic material, or may contain 80 mass% or more of an organic material. The photoelectric conversion layer 12b may contain only an organic material.

The thickness of the photoelectric conversion layer 12b is for example less than or equal to 1 $\mu$m. Reducing the thickness of the photoelectric conversion layer 12b in this way makes it hard for image quality to deteriorate even when the imaging device 100A is exposed to radiation.

Specifically, if the photoelectric conversion layer 12b is thin to such an extent as to be less than or equal to 1 $\mu$m, the generation of an electron-hole pair in the photoelectric conversion layer 12b by exposure of the photoelectric conversion layer 12b to radiation can be reduced. This makes it hard for a failed pixel to occur. It should be noted that in Examples 1 to 3, the thickness of the photoelectric conversion layer is 1 $\mu$m. Further reducing the thickness of the photoelectric conversion layer in Examples 1 to 3 is considered to bring about improvement in radiation resistance of the imaging device and a decrease in pixel failure probability.

The thickness of the photoelectric conversion layer 12b may be less than or equal to 0.8 $\mu$m, or may be less than or equal to 0.65 $\mu$m. The thickness of the photoelectric conversion layer 12b is for example greater than or equal to 0.2 $\mu$m. The thickness of the photoelectric conversion layer 12b may be greater than or equal to 0.3 $\mu$m.

The thickness of the photoelectric conversion layer 12b can be determined by a well-known technique. The thickness of the photoelectric conversion layer 12b can be determined, for example, in the following manner. First, an electronography of a cross-section of the photoelectric conversion layer 12b is acquired. Next, the image is used to measure thicknesses at any plurality of points of measurement (e.g. five points) of the photoelectric conversion layer 12b. The average value of those thicknesses at the plurality of points of measurement is employed as the thickness of the photoelectric conversion layer 12b.

In a typical example, in a plan view, the photoelectric conversion layer 12b is provided all over the pixel 10A. This configuration is advantageous from the point of view of ensuring the photoelectric conversion function in the pixel 10A.

In one example, the charge storage region FD contains an n-type impurity. Note, however, that the charge storage region FD may contain a p-type impurity.

In Examples 1 to 3, the resistance of the imaging device to proton beams was evaluated. Note, however, that the imaging device may be exposed to radiation other than proton beams. For example, the imaging device may be exposed to neutron beams. As with proton beams, neutron beams are hardly blocked by a shield, such as a metal plate, that the imaging device may have.

Assume here that the charge storage region contains boron. A collision of neutron beams with boron may generate secondary $\gamma$-rays and $\alpha$-rays. The $\gamma$-rays and $\alpha$-rays thus generated may cause deterioration in characteristic of the imaging device.

For example, as boron, $^{10}$B exists. Natural $^{10}$B has an abundance ratio of approximately 20%. $^{10}$B generates charged particles through the following nuclear fission reaction:

$$n(\text{neutron beams}) + {}^{10}B \rightarrow \alpha + {}^{7}Li + \gamma \ (94\%) \ (a)$$

$$\rightarrow \alpha + {}^{7}Li \ (6\%) \ (b)$$

The charge particles thus generated generate an electron-hole pair in the charge storage region FD. This may cause a failed pixel.

This problem may possibly be controlled by reducing the content of boron in the charge storage region FD or causing the charge storage region FD not to contain boron. For example, such a configuration may be employed that the charge storage region FD contains a substance other than boron as a major impurity. This configuration brings about an effect of making it hard for image quality to deteriorate even when the imaging device is exposed to radiation.

Note here that the major impurity of the charge storage region FD means the impurity that the charge storage region FD contains with the highest proportion by number of particles. The particle number of boron may be lower than or equal to 3% or may be lower than or equal to 1% of the total particle number of impurities of the charge storage region FD. The charge storage region FD may not contain boron at all.

Further, the charge storage region FD may contain, as a major impurity, a substance whose atomic number is larger than that of boron. The interaction between neutron beams and a material whose atomic number is large tends to be small. For this reason, this makes it hard for image quality to deteriorate even when the imaging device 100A is exposed to radiation.

The particle number of a substance whose atomic number is larger than that of boron may be higher than or equal to 50% or may be higher than or equal to 80% of the total particle number of the impurities of the charge storage region FD. The charge storage region FD may contain, as the only impurity, a substance whose atomic number is larger than that of boron.

It should be noted that the charge storage region FD may contain boron. Examples of n-type impurities that the charge storage region FD may contain include phosphorus, arsenic, and antimony. Examples of p-type impurities that the charge storage region FD may contain include boron and aluminum.

The following further describes the imaging device with reference to the terms "first transistor," "first gate electrode", "first source", "first drain", "second transistor", "second gate electrode", "first contact plug", and "first contact hole". The first transistor may correspond to a reset transistor 26. The first gate electrode may correspond to a gate electrode 26e. The first source and the first drain may correspond to the source and drain, respectively, of the reset transistor 26. The second transistor may correspond to an amplifying transistor 22. The second gate electrode may correspond to a gate electrode 22e. The first contact plug may correspond to a contact plug cp1. The first contact hole may correspond to a contact hole h1.

The aforementioned features of the reset transistor 26 are applicable to the first transistor. The aforementioned features of the gate electrode 26e is applicable to the first gate electrode. The aforementioned features of the source and drain of the reset transistor 26 are applicable to the first source and the first drain. The aforementioned features of the amplifying transistor 22 are applicable to the second transistor. The aforementioned features of the gate electrode 22e are applicable to the second gate electrode. The aforementioned features of the contact plug cp1 are applicable to the first contact plug. The aforementioned features of the contact hole h1 are applicable to the first contact hole.

According to one example, the imaging device 100A includes a first transistor, a second transistor, a first contact plug, and a first contact hole. The first transistor includes a first source, a first drain, and a first gate electrode. The second transistor includes a second gate electrode. The first source or the first drain is the charge storage region FD. The second gate electrode is electrically connected to the charge storage region FD. Specifically, the first contact plug electrically connects the first electrode to the charge storage region FD by being connected to the charge storage region FD via the first contact hole.

The expression "the first contact plug electrically connects the first electrode to the charge storage region FD" is described. This expression is a concept that encompasses an embodiment in which the first electrode and the charge storage region FD are electrically connected to each other solely by the first contact plug. This expression is a concept that encompasses an embodiment in which the first electrode and the charge storage region FD are electrically connected to each other by the first contact plug and another one or more members. The same applies to other similar expressions.

The area of the second gate electrode in plan view may be smaller than the area of the first gate electrode in plan view. Such a magnitude relationship makes it easy to reduce the area of the second gate electrode in plan view. When the area of the second gate electrode is small, it is easy to form a smaller channel region between the source and drain of the second transistor. This makes it easy to reduce a dark current based on electric charge that is trapped in the channel region.

Further, in a typical example, the second transistor has a gate insulating film between the second gate electrode and the semiconductor substrate 60. A defect may occur at the interface between the gate insulating film and the channel region. This defect may impair the function of the second transistor and cause a dark current to increase. However, the magnitude relationship makes it easy to reduce the area of the second gate electrode in plan and reduce the area of the interface. This is advantageous from the point of view of reducing a dark current. It should be noted that in the example shown in Fig. 4, the aforementioned gate insulating film may correspond, for example, to a portion of the insulating layer 70 between the gate electrode 26e and the semiconductor substrate 60. The gate insulating film is for example a gate oxide film.

As mentioned above, when the area of the second gate electrode is small, it is easy to make the channel region smaller. Further, in a case where the second transistor has a gate insulating film between the second gate electrode and the semiconductor substrate 60, it is easily to make the interface between the gate insulating film and the channel region smaller. These are expected to reduce a dark current that may be generated by the imaging device 100A being exposed to radiation.

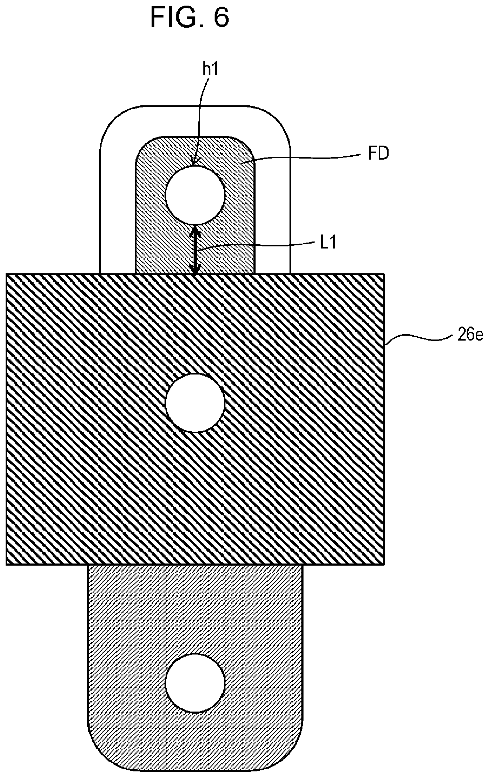

Fig. 6 is an explanatory diagram showing a spacing between a first contact hole and a first gate electrode in plan view. As mentioned above, the first contact hole may correspond to a contact hole h1. The first gate electrode may correspond to a gate electrode 26e. In Fig. 6 and a related description, the first contact hole is assigned the sign "h1". The first gate electrode is assigned the sign "26e". The spacing between the first contact hole and the first gate electrode is assigned the sign "L1". As can be understood from Fig. 6, the spacing L1 is in particular the length of the shortest segment connecting a point on the first contact hole h1 in plan view with a point on the first gate electrode 26e.

The spacing L1 between the first contact hole h1 and the first gate electrode 26e in plan view is for example smaller than or equal to 0.2 $\mu$m. The spacing L1 may be smaller than or equal to 0.184 $\mu$m, or may be smaller than or equal to 0.1 $\mu$m. When the spacing L1 is small, it is easy to reduce the area of the charge storage region FD in plan view. As mentioned above, reducing the area of the charge storage region FD makes it hard for image quality to deteriorate even when the imaging device 100A is exposed to radiation.

The spacing L1 is for example larger than or equal to 0.01 $\mu$m. The spacing L1 may be larger than or equal to 0.0316 $\mu$m.

It should be noted that 0.2 $\mu$m, 0.184 $\mu$m, and 0.1 $\mu$m, which are examples of upper limits on the spacing L1, correspond to square roots of 0.04 $\mu$m$^2$, 0.034 $\mu$m$^2$, and 0.01 $\mu$m$^2$, which are examples of upper limits on the area of the charge storage region FD in plan view, respectively. Further, 0.01 $\mu$m and 0.0316 $\mu$m, which are examples of lower limits on the spacing L1, correspond to square roots of 0.0001 $\mu$m$^2$ and 0.001 $\mu$m$^2$, which are examples of lower limits on the area of the charge storage region FD in plan view, respectively.

In the configuration shown in Fig. 1, the pixel 10A does not have a photodiode. This configuration makes it hard for a signal that the pixel 10A outputs to deteriorate even when the imaging device 100A is exposed to radiation.

In the configuration shown in Fig. 1, a photodiode is not present in a region overlapping the photoelectric conversion layer 12b in plan view. Specifically, the imaging device 100A does not have a photodiode.

In the typical imaging device 100A, the semiconductor substrate 60 is a silicon substrate. The semiconductor substrate 60 has a silicon crystal.

In the typical imaging device 100A, the charge storage region FD has a silicon crystal. This configuration makes it easy for a radiation resistance improvement effect to be expressed by the area of the charge storage region FD in plan view being small.

Note here that the radiation environment may be explained, for example, from the intensity of radiation per unit time. To cite a numerical example, the radiation environment may be an environment exposed to radiation whose intensity per unit time is higher than or equal to 0.11 microgray/hour ($\mu$Gy/h). Specifically, the radiation environment may be an environment exposed to radiation whose intensity per unit time is higher than or equal to 1 $\mu$Gy/h, more specifically higher than or equal to 3 $\mu$Gy/h, even more specifically higher than or equal to 5 $\mu$Gy/h. Further, the radiation environment may be an environment exposed to radiation whose intensity in a decade is higher than or equal to 0.05 Gy, specifically higher than or equal to 0.1 Gy, more specifically higher than or equal to 0.15 Gy.

Further, the radiation environment may be explained in the following manner. That is, the radiation environment may correspond to a space environment, an aeronautical environment, an environment exposed to reactor-derived radiation, an environment exposed to medical radiation, or other environments. Examples of movable bodies that fly in space include a spacecraft and an artificial satellite. Examples of movable bodies that fly in an aeronautical environment include an aircraft. In a typical example, the medical radiation is radiation derived from medical equipment. The imaging device 100A may be mounted on a spacecraft, an artificial satellite, an aircraft, or other apparatuses.

In one specific example, the imaging device 100A is mounted on a specific apparatus. The specific apparatus is operated for a predetermined period of time. The dose (fluence) of proton beams with which the imaging device 100A is irradiated in this predetermined period of time is defined as $\Phi$. In the formula $d/N = (F \times t \times S) \times P \times (1 - P)^{((F \times t \times S) - 1)}$, S is defined as a reference area when $d/N = 3.2 \times 10^{-3}$, $F \times t = \Phi$, and $P = 8.0 \times 10^{-4}$. At this point in time, the area of the charge storage region FD in plan view is smaller than or equal to the reference area. Reducing the area of the charge storage region FD in this way makes it hard for image quality to deteriorate even when the imaging device 100A is exposed to radiation. $d/N = 3.2 \times 10^{-3}$ may be substituted by $d/N = 2.7 \times 10^{-3}$, or may be substituted by $d/N = 8.0 \times 10^{-4}$. The specific apparatus is for example a spacecraft, an artificial satellite, an aircraft, a reactor, a radiological apparatus, or other apparatuses.

In the foregoing, an imaging device according to the present disclosure has been described with reference to an embodiment and examples; however, the present disclosure is not intended to be limited to the embodiment or the examples. Applications to the embodiment and the examples of various types of modification conceived of by persons skilled in the art and other embodiments constructed by combining some constituent elements of the embodiment and the examples are encompassed in the scope of the present disclosure, provided such applications and embodiments do not depart from the spirit of the present disclosure.

For example, the amplifying transistor 22, the address transistor 24, and the reset transistor 26 may each be an N-channel MOSFET or may be a P-channel MOSFET. In a case where each of the transistors is a P-channel MOSFET, the impurity of the first conductivity type is a p-type impurity, and the impurity of the second conductivity is an n-type impurity. All of these transistors do not need to be uniformly either N-channel MOSFETs or P-channel MOSFETs. In a case where each of the transistors in the pixel is an N-channel MOSFET and an electron is used as signal charge, the arrangement of the source and drain of each of these transistors needs only be reversed.

Industrial Applicability

An imaging device according to the present disclosure may output a signal with reduced deterioration even when exposed to radiation. Therefore, this imaging device may be used even under a high radiation environment as well as a terrestrial normal environment. Specifically, the development of application this imaging device to the field of radiology, a field that involves the use of reactors, the aerospace field, or other fields is possible.

An imaging device of the present disclosure is useful, for example, in an image sensor, a digital camera, or other devices. Further, the imaging device of the present disclosure can be used in a camera for medical use, a camera for use in a robot, a security camera, a camera mounted on a vehicle for use, a camera mounted on an aircraft, a camera mounted on a space satellite, a camera that monitors the status of the inside of a reactor, a camera mounted on a planetary rover, or other cameras.

Reference Signs List

    10A pixel
    12 photoelectric converter
    12a pixel electrode
    12b photoelectric conversion layer
    12c transparent electrode
    14 signal detection circuit
    16 feedback circuit
    22 amplifying transistor
    22e, 24e, 26e gate electrode
    24 address transistor
    26 reset transistor
    32 power wire
    34 address signal line
    35 vertical signal line
    36 reset signal line
    39 storage control line
    40 peripheral circuit
    42 load circuit
    44 column signal processing circuit
    46 vertical scanning circuit
    48 horizontal signal readout circuit
    49 horizontal common signal line
    50 inverting amplifier
    53 feedback line
    60 semiconductor substrate
    61 support substrate
    61p, 63p, 65p p-type semiconductor layer
    62n n-type semiconductor layer

64 p-type region
66p p-type impurity region
67a first region
67b second region
67n first diffusion region
68an second diffusion region
68bn, 68cn, 68dn n-type impurity region
69 element isolation region
70, 71, 72, 90a, 90b, 90c, 90d insulating layer
80 wiring structure
80a, 80b, 80c, 80d wiring layer
90 interlayer insulating layer
100A imaging device
FD charge storage region
ND charge storage node
R1 imaging region
R2 peripheral region
cp1, cp2, cp3, cp4, cp5, cp6, cp7 contact plug
h1, h2, h3, h4, h5, h6, h7 contact hole
pa1, pa2, pb, pc, pd plug

**Claims**

1. An imaging device comprising:

    a first electrode;
    a second electrode;
    a photoelectric conversion layer located between the first electrode and the second electrode; and
    a charge storage region electrically connected to the first electrode,
    wherein an area of the charge storage region in plan view is smaller than or equal to 0.04 $\mu$m$^2$.

2. The imaging device according to claim 1, wherein the area of the charge storage region in plan view is smaller than or equal to 0.034 $\mu$m$^2$.

3. The imaging device according to claim 2, wherein the area of the charge storage region in plan view is smaller than or equal to 0.01 $\mu$m$^2$.

4. The imaging device according to any one of claims 1 to 3, further comprising a pixel including:

    the first electrode;
    the second electrode;
    the photoelectric conversion layer; and
    the charge storage region,
    wherein a ratio of the area of the charge storage region in plan view to an area of the pixel in plan view is lower than or equal to 0.44%.

5. The imaging device according to any one of claims 1 to 4, wherein the photoelectric conversion layer contains an organic material as a major ingredient.

6. The imaging device according to any one of claims 1 to 5, wherein a thickness of the photoelectric conversion layer is less than or equal to 1 $\mu$m.

7. The imaging device according to any one of claims 1 to 6, wherein the charge storage region contains an n-type impurity.

8. The imaging device according to any one of claims 1 to 7, wherein the charge storage region contains a substance other than boron as a major impurity.

9. The imaging device according to any one of claims 1 to 8, wherein the charge storage region contains, as a major impurity, a substance whose atomic number is larger than atomic number of boron.

10. The imaging device according to any one of claims 1 to 9, further comprising:

    a first transistor; and
    a second transistor, wherein
    the first transistor includes a first source, a first drain, and a first gate electrode,
    the second transistor includes a second gate electrode,
    the first source or the first drain is the charge storage region,
    the second gate electrode is electrically connected to the charge storage region, and
    an area of the second gate electrode in plan view is smaller than an area of the first gate electrode in plan view.

11. The imaging device according to any one of claims 1 to 9, further comprising:

    a first transistor;
    a first contact plug; and
    a first contact hole, wherein
    the first transistor includes a first source, a first drain, and a first gate electrode,
    the first source or the first drain is the charge storage region,
    the first contact plug electrically connects the first electrode to the charge storage region by being connected to the charge storage region via the first contact hole, and
    a spacing between the first contact hole and the first gate electrode in plan view is smaller than or equal to $0.2\ \mu m$.

12. The imaging device according to any one of claims 1 to 11, further comprising a pixel including:

    the first electrode;
    the second electrode;
    the photoelectric conversion layer; and
    the charge storage region,
    wherein the pixel does not include a photodiode.

13. The imaging device according to any one of claims 1 to 12, wherein the imaging device is used under an environment exposed to radiation.

14. An imaging device comprising:

    a first electrode;
    a second electrode;
    a photoelectric conversion layer located between the first electrode and the second electrode;
    a first transistor;
    a first contact plug; and
    a first contact hole, wherein
    the first transistor includes a first source, a first drain, and a first gate electrode,
    the first source or the first drain is the charge storage region,
    the first contact plug electrically connects the first electrode to the charge storage region by being connected to the charge storage region via the first contact hole, and
    a spacing between the first contact hole and the first gate electrode in plan view is smaller than or equal to $0.2\ \mu m$,

# FIG. 1

# FIG. 2

# FIG. 3

# FIG. 4

10A

FIG. 5

AREA OF CHARGE STORAGE REGION
IN PLAN VIEW $[\mu m^2]$

# FIG. 6

## INTERNATIONAL SEARCH REPORT

| International application No. |
|---|
| **PCT/JP2021/025294** |

**A.    CLASSIFICATION OF SUBJECT MATTER**

*H01L 27/146*(2006.01)i; *H01L 27/144*(2006.01)i; *H04N 5/369*(2011.01)i
FI:    H01L27/146 E; H01L27/144 K; H01L27/146 A; H04N5/369

According to International Patent Classification (IPC) or to both national classification and IPC

**B.    FIELDS SEARCHED**

Minimum documentation searched (classification system followed by classification symbols)

H01L27/146; H01L27/144; H04N5/369

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| X | JP 2019-029656 A (PANASONIC INTELLECTUAL PROPERTY MANAGEMENT CO., LTD.) 21 February 2019 (2019-02-21) paragraphs [0042]-[0061], [0064]-[0069], [0081]-[0087], fig. 2-5, 7 | 1-2, 12 |
| Y | | 3-11, 13-14 |
| Y | JP 2020-057776 A (PANASONIC INTELLECTUAL PROPERTY MANAGEMENT CO., LTD.) 09 April 2020 (2020-04-09) paragraphs [0039]-[0075], fig. 2, 3 | 1-14 |
| Y | WO 2013/128998 A1 (SONY CORP.) 06 September 2013 (2013-09-06) paragraphs [0047]-[0050], fig. 2, 3 | 1-14 |
| Y | JP 2008-124395 A (MATSUSHITA ELECTRIC INDUSTRIAL CO., LTD.) 29 May 2008 (2008-05-29) paragraphs [0029], [0037], [0047]-[0051], fig. 1, 3 | 10, 13 |
| Y | JP 2013-044725 A (FUJIFILM CORP.) 04 March 2013 (2013-03-04) paragraphs [0001], [0037]-[0039], fig. 1 | 13 |

☐ Further documents are listed in the continuation of Box C.    ☑ See patent family annex.

| | |
|---|---|
| *    Special categories of cited documents: | "T"    later document published after the international filing date or priority date and not in conflict with the application but cited to understand the principle or theory underlying the invention |
| "A"    document defining the general state of the art which is not considered to be of particular relevance | |
| "E"    earlier application or patent but published on or after the international filing date | "X"    document of particular relevance; the claimed invention cannot be considered novel or cannot be considered to involve an inventive step when the document is taken alone |
| "L"    document which may throw doubts on priority claim(s) or which is cited to establish the publication date of another citation or other special reason (as specified) | "Y"    document of particular relevance; the claimed invention cannot be considered to involve an inventive step when the document is combined with one or more other such documents, such combination being obvious to a person skilled in the art |
| "O"    document referring to an oral disclosure, use, exhibition or other means | |
| "P"    document published prior to the international filing date but later than the priority date claimed | "&"    document member of the same patent family |

| Date of the actual completion of the international search | Date of mailing of the international search report |
|---|---|
| **21 September 2021** | **28 September 2021** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

INTERNATIONAL SEARCH REPORT
Information on patent family members

| International application No. |
|---|
| **PCT/JP2021/025294** |

| Patent document cited in search report | | | Publication date (day/month/year) | Patent family member(s) | | | Publication date (day/month/year) |
|---|---|---|---|---|---|---|---|
| JP | 2019-029656 | A | 21 February 2019 | US | 2019/0035832 | A1 | |
| | | | | paragraphs [0047]-[0065], [0069]-[0074], [0086]-[0092], fig. 2-5, 7 | | | |
| | | | | US | 2021/0013252 | A1 | |
| | | | | EP | 3435417 | A2 | |
| | | | | CN | 109300923 | A | |
| JP | 2020-057776 | A | 09 April 2020 | CN | 110970453 | A | |
| WO | 2013/128998 | A1 | 06 September 2013 | US | 2015/0021461 | A1 | |
| | | | | paragraphs [0060]-[0063], fig. 2, 3 | | | |
| | | | | EP | 2822270 | A1 | |
| | | | | CN | 104170372 | A | |
| JP | 2008-124395 | A | 29 May 2008 | (Family: none) | | | |
| JP | 2013-044725 | A | 04 March 2013 | US | 2013/0048865 | A1 | |
| | | | | paragraphs [0002], [0058], [0059], fig. 1 | | | |
| | | | | CN | 102956659 | A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2016013227 A
- WO 2019221095 A
- WO 2012147302 A